# EUROPEAN PATENT APPLICATION

(11) **EP 3 051 692 A1**
(43) Date of publication of application: **03.08.2016**
(21) Application number: 15305140.4
(22) Date of filing: 30.01.2015
(51) Int. Cl.: H03F 3/08, H01S 5/50, H04B 10/291

(54) **OPTICAL DEVICE WITH SEMICONDUCTOR OPTICAL AMPLIFIER WITH AUTOMATIC CURRENT SUPPLY CONTROL**

(71) Applicant: ALCATEL LUCENT, 92100 Boulogne-Billancourt (FR); Commissariat à l'Energie Atomique et aux Energies Alternatives, 75015 Paris (FR)
(72) Inventor: CAILLAUD, Christophe, 91460 Marcoussis (FR); DUPUY, Jean-Yves, 91460 Marcoussis (FR)
(74) Representative: Novagraaf Technologies

(57) **Abstract**

An optical device (1) comprises a semiconductor optical amplifier (2) with an optical signal input and a current supply anode connected to an output of a current supply circuit (4), and a control circuit (3) comprising a first input (6) connected to this current supply anode and an output connected to a control input of this current supply circuit (4), and arranged for determining a voltage across the semiconductor optical amplifier (2) and for authorizing the current supply circuit (4) to supply the semiconductor optical amplifier (2) with a current when this determined voltage becomes greater than a chosen threshold.

## Description

### Field of the Invention

The present invention relates to optical devices comprising a semiconductor optical amplifier (or SOA), and more precisely to the control of the current supply of such optical devices.

### Background

Semiconductor optical amplifiers (or SOAs) are very promising components, notably for network access or for providing optical preamplification. This results from the fact that they are cheaper and less bulky than optical fiber amplifiers.

But, the electric consumption of SOAs is important and becomes a real concern of network designers, especially in access networks and in optical preamplification. So, it has been proposed to add a standby function to SOAs to avoid electric consumption during the phases in which they do not receive any optical signal.

To this effect it is possible to control the optical power arriving onto an SOA input by taking a part of the incoming optical signal by means of a coupler and then to feed a photodiode with this taken part. Thanks to control circuits the current injected into the SOA can be adjusted as a function of the incoming optical power, and therefore it is possible to switch off its current supply when it does not receive any optical signal. Unfortunately this solution has at least two drawbacks. Indeed, it requires several additional components such as a coupler and a photodiode, which increases the cost and the device dimensions significantly. Moreover, the coupler adds losses on the SOA input, which increases its noise factor (typically if the coupler takes 10% of the input optical power, then the noise factor is increased by 0.5 dB).

### Summary

So an object of this invention is to improve the situation, and more precisely to allow a current supply control of an SOA with a minimum add of complexity and without degrading its performances.

In an embodiment, an optical device comprises:
- a semiconductor optical amplifier with an optical signal input and a current supply anode connected to an output of a current supply circuit, and
- a control circuit comprising a first input connected to the current supply anode and an output connected to a control input of the current supply circuit, and arranged for determining a voltage across the semiconductor optical amplifier and for authorizing the current supply circuit to supply the semiconductor optical amplifier with a current when the determined voltage becomes greater than a chosen threshold.

The optical device may include additional characteristics considered separately or combined, and notably:
- it may comprise a monitoring circuit connected to a second input of the control circuit and coupled to an optical signal output of the semiconductor optical amplifier, and arranged for controlling a level of an authorization signal, that is outputted by the control circuit for driving the intensity of the current delivered by the current supply circuit, as a function of the power of the amplified optical signal outputted by the optical signal output of the semiconductor optical amplifier;
- in a variant, the current supply circuit may be switched on by the control circuit when the voltage of the first input moves from a low level to a high level and may be switched off when the voltage of the second input of the control circuit moves from a high level to a low level;
- when the optical signal input of the semiconductor optical amplifier receives no optical power, the current supply circuit is switched off and the values on the first and second inputs of the control circuit are both equal to 0, defining a first state of a state machine, and when an incoming optical signal arrives on the optical input of the semiconductor optical amplifier, the value on the first input passes from 0 to 1 and triggers the generation of an authorization signal by the control circuit, which induces the current supply of the semiconductor optical amplifier by the current supply circuit and, by means of the output signal of the semiconductor optical amplifier, transitions the value on the second input from 0 to 1, putting the control circuit in a second state of the state machine, and the state machine returns to the first state when the value of the second input passes from 1 to 0 which occurs when there is no more optical power at the optical input of the semiconductor optical amplifier.

- in a first embodiment, the SOA can be used in a preamplified receiver comprising a SOA and a photodiode. In this case the monitoring circuit comprises the photodiode which is connected to the second input of the control circuit, to the optical signal output of the semiconductor optical amplifier, and to a first voltage supply circuit, and arranged for delivering an electrical signal representative of the amplified optical signal power;
- in this first embodiment, the control circuit may comprise another output arranged for delivering another authorization signal intended for authorizing the first voltage supply circuit to supply the photodiode with a voltage when the determined voltage becomes greater than the chosen threshold;
- in a second embodiment, the SOA may be used in a preamplified receiver comprising a SOA, a photodiode and an electronic circuit. In this case the monitoring circuit comprises i) the photodiode which may be connected to the optical signal output of the semiconductor optical amplifier and to a first voltage supply circuit, and arranged for delivering an electrical signal representative of the amplified optical signal power on an output, and ii) the electronic circuit which may be connected to the second input of the control circuit, to the output of the photodiode and to an output of a second voltage supply circuit, and arranged for controlling the authorization signal level with a signal representative of the electrical signal outputted by the photodiode and representative of the amplified optical signal power;

- in this second embodiment the control circuit may comprise another output arranged for delivering another authorization signal intended for authorizing the first voltage supply circuit to supply the photodiode with a voltage and/or the second voltage supply circuit to supply the electronic circuit with another voltage when the determined voltage becomes greater than the chosen threshold;
- in a third embodiment, the SOA may be used outside of a preamplified receiver, as an in-line amplifier or as a booster amplifier. In this case the monitoring circuit may comprise i) an optical coupler connected to the optical signal output of the semiconductor optical amplifier, and comprising a first and second outputs for delivering respectively first and second chosen parts of the amplified optical signal power, and ii) a photodiode connected to the second input of the control circuit, to the second output of the optical coupler, and to a first voltage supply circuit, and arranged for delivering an electrical signal representative of this second part of the amplified optical signal power;
- in this third embodiment the control circuit may comprise another output arranged for delivering another authorization signal intended for authorizing the first voltage supply circuit to supply the photodiode with a voltage when the determined voltage becomes greater than the chosen threshold;
- the control circuit may comprise an analog to digital converter connected to its second input and arranged for continuously adjusting the level of the authorization signal as a function of the power of the amplified optical signal outputted by the optical signal output of the semiconductor optical amplifier;
- it may further comprise a cooling means arranged for cooling at least the semiconductor optical amplifier when the determined voltage becomes greater than the chosen threshold.

### Brief Description of the Figures

Some embodiments of an optical device in accordance with embodiments of the present invention are now described, by way of example only, and with reference to the accompanying drawings, in which:
- Figure 1 schematically and functionally illustrates a first example of embodiment of an optical device according to the invention, which defines an in-line optical amplifier;
- Figure 2 schematically and functionally illustrates a second example of embodiment of an optical device according to the invention, which defines a signal receiver with an optical pre-amplifier;
- Figure 3 schematically and functionally illustrates a third example of embodiment of an optical device according to the invention, which defines a signal receiver with an optical pre-amplifier and without electronic circuit; and
- Figure 4 schematically and functionally illustrates a fourth example of embodiment of an optical device according to the invention, which defines a signal receiver with an optical pre-amplifier and an electronic circuit for amplification and/or signal processing.

### Description of Embodiments

Hereafter is notably disclosed an optical device 1 comprising a semiconductor optical amplifier (or SOA) 2 and control means for controlling the current supply of at least this semiconductor optical amplifier 2.

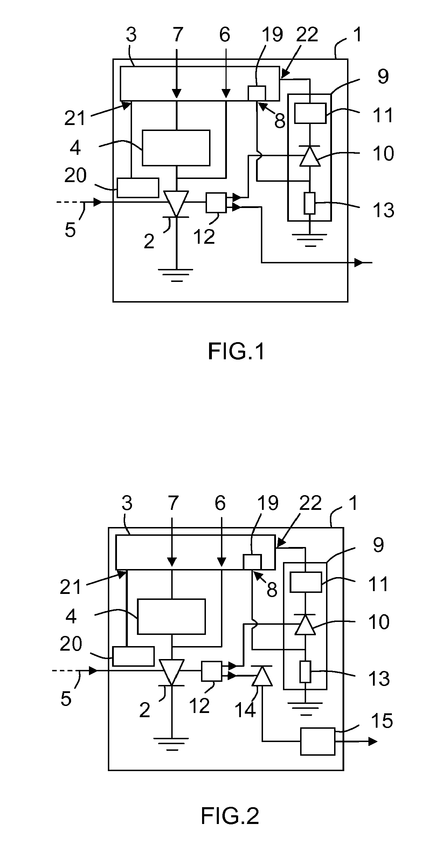

As illustrated in Figures 1 to 4, an optical device 1 according to the invention comprises at least a semiconductor optical amplifier (or SOA) 2, a control circuit 3 and a current supply circuit 4 coupled together. To this effect, the control circuit 3 may be, for instance, manufactured in CMOS technology in order to minimize the electric consumption or in bipolar technology in order to maximize the working speed.

The semiconductor optical amplifier 2 comprises an optical signal input that is intended to be connected to a terminal of an optic fiber 5, and a current supply anode that is connected to an output of the current supply circuit 4.

The control circuit 3 comprises at least a first input 6 connected to the current supply anode of the semiconductor optical amplifier 2, and a first output 7 connected to a control input of the current supply circuit 4. This control circuit 3 is arranged for determining a voltage across the semiconductor optical amplifier 2 and for authorizing the current supply circuit 4 to supply the semiconductor optical amplifier 2 with a current when this determined voltage becomes greater than a chosen threshold. In fact, the control circuit 3 does not care about the level of the voltage but about the variation of the voltage. So, if the SOA 2 is supplied the voltage level of the first input 6 has no effect, and if the SOA 2 is not supplied it will be supplied if the voltage level of the first input 6 moves from below the chosen threshold to greater than the chosen threshold.

The chosen threshold depends on the SOA 2 and on its use conditions.

The first input 6 of the control circuit 3 has preferably a high impedance in order to not be disturbed by the current supply of the semiconductor optical amplifier 2 that is done by the current supply circuit 4 via the current supply anode, and vice versa.

The invention is based on the fact that when there is no current supplying the semiconductor optical amplifier 2, it acts as a photovoltaic detector, and when an incoming optical signal arrives on the optical signal input of this semiconductor optical amplifier 2, it appears a voltage across the SOA 2. So, when connecting the current supply anode of the semiconductor optical amplifier 2 to the high impedance first input 6 of the control circuit 3 (which offers a comparison function), this control circuit 3 is able to detect the arrival of an incoming optical signal and therefore to trigger current supply of the semiconductor optical amplifier 2 in order it could amplify this incoming optical signal.

When the SOA 2 is supplied by the current supply circuit 4, the voltage across the semiconductor optical amplifier 2 is quasi independent of the incoming optical power because it is mainly set by the current injected into the semiconductor optical amplifier 2 via its current supply anode.

Preferably, and as illustrated in the non-limiting examples of Figures 1 to 4, the control circuit 3 comprises a second input 8 that receives a signal indicating at least when the current supply of the semiconductor optical amplifier 2 must be stop temporarily.

As the voltage across the semiconductor optical amplifier 2 depends of the incoming optical power, it is possible to implement a gain control function by making the current injected into the semiconductor optical amplifier 2 dependent from the voltage across the SOA 2 when its current supply begins.

For instance, without incoming optical power, the current supply is switched off and the values on the first 6 and second 8 inputs of the control circuit 3 are both equal to 0 (which defines a first state). When the first input 6 is set to 0, the second input 8 must be also set to 0 because the semiconductor optical amplifier 2 does not output any optical signal. When an incoming optical signal arrives on the optical input of the semiconductor optical amplifier 2, a voltage appears across the SOA 2, and therefore the value on the first input 6 passes from 0 to 1. This value transition triggers the generation of an authorization signal by the control circuit 3, which induces the current supply of the semiconductor optical amplifier 2 by the current supply circuit 4. As an optical signal is now outputted by the optical signal output of the semiconductor optical amplifier 2, the value on the second input 8 passes also from 0 to 1. So, the control circuit 3 is now in a second state. For leaving this second state to come back to the first state, the value of the second input 8 must pass from 1 to 0. This occurs when there is no more optical power at the input of the SOA which induces that the optical signal outputted by the SOA is only its amplified spontaneous emission (ASE), and this induces a new switch off of the current supply and then the drop to 0 of the voltage across the semiconductor optical amplifier 2 which induces the transition from 1 to 0 of the first input value. When the control circuit 3 is in the first state, i.e. both inputs at 0, the value of the second input 8 has no influence and when the control circuit 3 is in the second state, i.e. both inputs at 1, the value of the first input 6 has no influence.

For instance, the current supply circuit 4 may be switched on by the control circuit 3 when the voltage of the first input 6 moves from a low level to a high level and may be switched off when the voltage of the second input 8 of the control circuit 3 moves from a high level to a low level.

To allow the control of the power of the optical signal outputted by the optical signal output of the semiconductor optical amplifier 2, the optical device 1 may comprise a monitoring circuit 9 connected to the second input 8 of the control circuit 3 and coupled to this optical signal output. This monitoring circuit 9 is arranged for controlling a level of an authorization signal, that is outputted by the control circuit 3 for driving the intensity of the current delivered by the current supply circuit 4, as a function of the power of the optical signal outputted by the optical signal, output of the semiconductor optical amplifier 2.

For instance, and as illustrated in the non-limiting example of Figures 1 to 4, the monitoring circuit 9 may comprise a photodiode 10 intended for controlling the authorization signal level directly or indirectly, and a first voltage supply circuit 11 for supplying this photodiode 10.

In the first example of embodiment illustrated in Figure 1, the optical device 1 defines an in-line optical amplifier, and therefore does not comprise any component for processing the amplified optical signal outputted by the optical signal, output of the semiconductor optical amplifier 2. So, the monitoring circuit 9 comprises an optical coupler 12 in addition to the photodiode 10 and the first voltage supply circuit 11.

The optical coupler 12 is connected to the optical signal output of the semiconductor optical amplifier 2, and comprises a first output for delivering a first chosen part of the amplified optical signal power to an output of the optical device 1, and a second output for delivering a second chosen part of the amplified optical signal power to the photodiode 10. For instance the first and second parts may be respectively equal to 90% and 10% of the outputted amplified optical signal power.

The photodiode 10 is connected directly to the second input 8 of the control circuit 3 and to the first voltage supply circuit 11, and is arranged for delivering a signal representative of the second part of the outputted optical signal power.

Preferably, a load resistance 13 is mounted in parallel between the ground and the output of the photodiode 10 that is connected to the second input 8. For instance, in a preamplified receiver this load resistance may be equal to 50 Ω to allow for a better quality of the HF signal outing the photodiode 10. In an in-line amplifier, such as the example of Figure 1, where the photodiode is here only to check the output power of the SOA 2, a bigger resistance is preferable to have higher voltage. In these cases the value of the second input 8 of the control circuit 3 is given by the voltage across the load resistance 13. Indeed, the voltage across the load resistance 13 is representative of the current IPD generated by the photodiode 10 and which is linked to the incoming optical signal power (IPD = IASE + IS, where IASE is the current generated by the amplified spontaneous emission (or ASE) produced by the semiconductor optical amplifier 2 and IS the current generated by the input optical power amplified by the semiconductor optical amplifier 2).

For instance, and as illustrated in the non-limiting first example of Figure 1, the control circuit 3 may comprise a second output 22 arranged for delivering another authorization signal that is intended for authorizing the first voltage supply circuit 11 to supply the photodiode 10 with an appropriate voltage when the voltage determined across the semiconductor optical amplifier 2 becomes greater than the chosen threshold. This allows to supply only the photodiode 10 when the semiconductor optical amplifier 2 effectively starts to receive an incoming optical signal, and therefore to still more minimize the electric consumption.

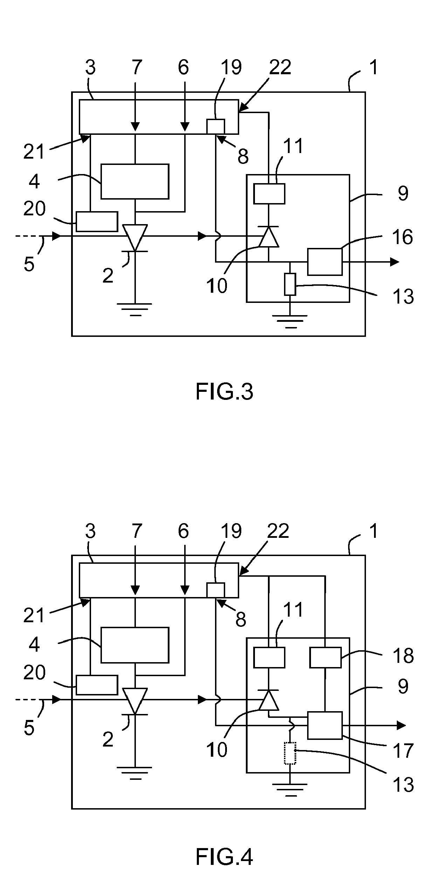

In the second example of embodiment illustrated in Figure 2, the optical device 1 defines a signal receiver with an optical pre-amplifier, and therefore comprises two components 14 and 15. As it will be discussed below in relation with Figures 3 and 4, the man skilled in the art may realize that the functions of the photodiodes 10 and 14 may be merged. In this case the component 15 can be connected directly to the anode of the photodiode 10 as it is described in Figure 3. In this second example, the second control circuit 9 is identical to the one of the first example (described above and illustrated in Figure 1).

The first component 14 is another photodiode that comprises an input connected to the optical signal output of the semiconductor optical amplifier 2 for receiving the first part of the outputted amplified optical signal power, and arranged for converting this first part into an electrical signal before feeding the second component 15. The first component 14 is connected to a voltage supply (not represented).

The second component 15 is a processing circuit acting as a receiver and fed with electrical signals by the output of the photodiode 14. The processing circuit 15 outputs an electrical signal containing information representative of the information contained in the optical signal 5. Examples of the processing circuit 15 are electrical connector, amplifier, clock recovery circuit or decision circuit.

In the third example of embodiment illustrated in Figure 3, the optical device 1 defines an optical receiver. The main difference between this third example and the second one resides in the fact that there is only one photodiode 10 for controlling the authorization signal level directly and for converting the amplified optical signals outputted by the optical signal output of the semiconductor optical amplifier 2 into electrical signals before feeding a processing circuit 16 acting as a receiver. The processing circuit 16 could be a separate module which can vary depending on the application. For instance, the processing circuit 16 could be also an output connector to connect the photodiode 10 to an external circuit or sensor depending on the application.

So, in this third example the monitoring circuit 9 comprises at least the photodiode 10, the first voltage supply circuit 11, and the processing circuit 16.

The photodiode 10 is connected directly to the second input 8 of the control circuit 3, to the first voltage supply circuit 11 and to the input of the processing circuit 16, and is arranged for converting the amplified optical signals outputted by the optical signal output of the semiconductor optical amplifier 2 into an electrical signal before feeding both the processing circuit 16 and the control circuit 3.

The processing circuit 16 is connected to the output of the photodiode 10 in order to be fed with the signals it outputs.

Preferably, a load resistance 13 is mounted in parallel between the ground and the output of the photodiode 10 that is connected to the second input 8. For instance, this load resistance may be equal to 50 Ω. In this case the value of the second input 8 of the control circuit 3 is the voltage across the load resistance 13 and therefore to the optical power coupled into the photodiode 10.

Also for instance, and as illustrated in the non-limiting first example of Figure 3, the control circuit 3 may comprise a second output 22 arranged for delivering another authorization signal that is intended for authorizing the first voltage supply circuit 11 to supply the photodiode 10 with an appropriate voltage when the SOA supply current circuit 4 is switched on. This allows to supply only the photodiode 10 when the semiconductor optical amplifier 2 effectively starts to receive an incoming optical signal, and therefore to still more minimize the electric consumption.

In the fourth example of embodiment illustrated in Figure 4, the optical device 1 defines a signal receiver with an optical pre-amplifier and an electronic circuit 17 which could be a transimpedance amplifier, a decision circuit or a clock recovery circuit. The main difference between this fourth example and the third one resides in the fact that an electronic circuit for signal amplification or signal processing is included in the device and that the input 8 of the control circuit 3 is now linked to an output of the electronic circuit 17. This electronic circuit 17 could be also linked to a connector or to another circuit for signal processing; in a sense it is a special type of the processing circuit 16.

So, in this fourth example the monitoring circuit 9 comprises at least the photodiode 10, the first voltage supply circuit 11, the electronic circuit 17 and a second voltage supply circuit 18.

The photodiode 10 is connected directly to the first voltage supply circuit 11 and to the input of the electronic circuit 17, and is arranged for converting the amplified optical signals outputted by the optical signal output of the semiconductor optical amplifier 2 into an electrical signal before feeding only the electronic circuit 17.

The electronic circuit 17 is connected to the output of the photodiode 10 in order to be fed with the electrical signal it outputs, to the output of second voltage supply circuit 18 to be fed with a supply voltage, and to the second input 8 of the control circuit 3 for controlling the authorization signal level with a signal representative of the electrical signal outputted by the photodiode 10 and representative of the outputted amplified optical signal power and to an electrical connector for practical use of the device.

In particular, in Figure 3, the processing circuit 16 can be a connector to connect the preamplified receiver to another component, while in Figure 4 the component 17 is an electronic and therefore the load resistance 13 is an optional element and the electronic circuit has an output directly linked to the second input 8 and is then connected to a connector for practical use of the component 17. For instance the output of the electronic circuit 17, that is connected to the second input 8 of the control circuit 3, may be either proportional to the mean current of the photodiode 10, or of a RSSI type (which means that it follows the high frequency power outing the photodiode 10 to free itself from the amplified spontaneous emission current (IASE) produced by the semiconductor optical amplifier 2).

Preferably, a load resistance 13 is mounted in parallel between the ground and the output of the photodiode 10 that is connected to the second input 8 if there is no electrical circuit 16, 17 in the device 1. For instance, this load resistance may be equal to 50 Ω. In this case the value of the second input 8 of the control circuit 3 is given by the voltage across the load resistance 13. But if the electronic circuit 17 is a tranimpedance amplifier and is connected to the photodiode 10, the resistance 13 may be avoided.

Also for instance, and as illustrated in the non-limiting fourth example of Figure 4, the control circuit 3 may comprise a second output 22 arranged for delivering another authorization signal that is intended for authorizing the first voltage supply circuit 11 to supply the photodiode 10 with an appropriate supply voltage and/or the second voltage supply circuit 18 to supply the electronic circuit 17 with an appropriate supply voltage, when the voltage determined across the semiconductor optical amplifier 2 becomes greater than the chosen threshold. This allows to only supply the photodiode 10 and/or the trans-impedance amplifier 17 when the semiconductor optical amplifier 2 effectively starts to receive an incoming optical signal, and therefore to still more minimize the electric consumption.

Also for instance, and as illustrated in the non-limiting examples of Figures 1 to 4, the control circuit 3 may comprise an analog to digital converter 19 connected to its second input 8 and arranged for continuously adjusting the level of the authorization signal as a function of the power of the amplified optical signal outputted by the optical signal output of the semiconductor optical amplifier 2. This option is notably interesting in access networks when it concerns a transmission from a client to a network operator because the traffic in packet mode shows very different powers from one data packet to another one, and therefore the control circuit 3 may allow the semiconductor optical amplifier 2 to equalize the amplified optical signals it outputs. The level of the amplified signal is measured by the analog to digital converter 19 and the current supply of the SOA 2 is adjusted via the first output 7 of the control circuit 3.

Also for instance, and as illustrated in the non-limiting examples of Figures 1 to 4, the optical device 1 may comprise a cooling means 20 arranged for cooling at least the semiconductor optical amplifier 2 when the voltage determined across the semiconductor optical amplifier 2 becomes greater than the chosen threshold. So, the control circuit 3 comprises a third output 21 intended for providing the cooling means 20 with another authorization signal when the determined voltage becomes greater than a chosen threshold (when the supply current of the SOA 2 is turned on). This allows minimizing the electric consumption.

For instance the cooling means 20 may provide a cooling by means of a Peltier effect.

The invention allows triggering at low cost a standby of the current supply of at least the semiconductor optical amplifier 2 when it does not receive any optical signal, in order to minimize the electric consumption. It allows also, in some embodiments, to do without coupler and additional photodiode, which reduces notably the cost and the bulkiness.

It should be appreciated by those skilled in the art that any block diagram herein represent conceptual views of illustrative circuitry embodying the principles of the invention.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. Optical device (1) comprising a semiconductor optical amplifier (2) with an optical signal input and a current supply anode connected to an output of a current supply circuit (4), and a control circuit (3) comprising a first input (6) connected to said current supply anode and an output connected to a control input of said current supply circuit (4), and arranged for determining a voltage across said semiconductor optical amplifier (2) and for authorizing said current supply circuit (4) to supply said semiconductor optical amplifier (2) with a current when said determined voltage becomes greater than a chosen threshold.

2. Optical device according to claim 1, wherein it comprises a monitoring circuit (9) connected to a second input (8) of said control circuit (3) and coupled to an optical signal output of said semiconductor optical amplifier (2), and arranged for controlling a level of an authorization signal, that is outputted by said control circuit (3) for driving the intensity of said current delivered by said current supply circuit (4), as a function of the power of the amplified optical signal outputted by said optical signal output of said semiconductor optical amplifier (2).

3. Optical device according to claim 1, wherein said current supply circuit (4) is switched on by said control circuit (3) when the voltage of said first input (6) moves from a low level to a high level and is switched off when the voltage of said second input (8) of the control circuit (3) moves from a high level to a low level.

4. Optical device according to claim 3, wherein, when the optical signal input of the semiconductor optical amplifier (2) receives no optical power, the current supply circuit (4) is switched off and the values on the first (6) and second (8) inputs of the control circuit (3) are both equal to 0, defining a first state of a state machine, and when an incoming optical signal arrives on the optical input of the semiconductor optical amplifier (2), the value on the first input (6) passes from 0 to 1 and triggers the generation of an authorization signal by the control circuit (3), which induces the current supply of the semiconductor optical amplifier (2) by the current supply circuit (4) and, by means of the output signal of the semiconductor optical amplifier (2), transitions the value on the second input (8) from 0 to 1, putting the control circuit (3) in a second state of the state machine, and the state machine returns to the first state when the value of the second input (8) passes from 1 to 0 which occurs when there is no more optical power at the optical input of the semiconductor optical amplifier (2).

5. Optical device according to one of claims 2 and 4, wherein said monitoring circuit (9) comprises a photodiode (10) connected to said second input (8) of said control circuit (3), to said optical signal output of said semiconductor optical amplifier (2), and to a first voltage supply circuit (11), and arranged for delivering an electrical signal representative of said amplified optical signal power.

6. Optical device according to one of claims 2 to 5, wherein said control circuit (3) comprises another output arranged for delivering another authorization signal intended for authorizing said first voltage supply circuit (11) to supply said photodiode (10) with a voltage when said determined voltage becomes greater than said chosen threshold.

7. Optical device according to one of claims 2, 3 and 4, wherein said monitoring circuit (9) comprises i) a photodiode (10) connected to said optical signal output of said semiconductor optical amplifier (2) and to a first voltage supply circuit (11), and arranged for delivering an electrical signal representative of said amplified optical signal power on an output, and ii) an electronic circuit (17) connected to said second input (8) of said control circuit (3), to said output of said photodiode (10) and to an output of a second voltage supply circuit (18), and arranged for controlling said authorization signal level with a signal representative of the electrical signal outputted by said photodiode (10) and representative of said amplified optical signal power.

8. Optical device according to claim 7, wherein said control circuit (3) comprises another output arranged for delivering another authorization signal intended for authorizing said first voltage supply circuit (11) to supply said photodiode (10) with a voltage and/or said second voltage supply circuit (18) to supply said electronic circuit (17) with another voltage when said determined voltage becomes greater than said chosen threshold.

9. Optical device according to one of claims 2, 3 and 4, wherein said monitoring circuit (9) comprises i) an optical coupler (12) connected to said optical signal output of said semiconductor optical amplifier (2), and comprising first and second outputs for delivering respectively first and second chosen parts of said amplified optical signal power, and ii) a photodiode (10) connected to said second input (8) of said control circuit (3), to said second output of said optical coupler (12), and to a first voltage supply circuit (11), and arranged for delivering an electrical signal representative of said second part of said amplified optical signal power.

10. Optical device according to claim 9, wherein said control circuit (3) comprises another output arranged for delivering another authorization signal intended for authorizing said first voltage supply circuit (11) to supply said photodiode (10) with a voltage when said determined voltage becomes greater than said chosen threshold.

11. Optical device according to one of claims 2 to 10, wherein said control circuit (3) comprises an analog to digital converter (19) connected to its second input and arranged for continuously adjusting the level of said authorization signal as a function of the power of the amplified optical signal outputted by said optical signal output of said semiconductor optical amplifier (2).

12. Optical device according to one of claims 1 to 11, wherein it comprises a cooling means (20) arranged for cooling at least said semiconductor optical amplifier (2) when said determined voltage becomes greater than said chosen threshold.
